# EUROPEAN PATENT SPECIFICATION

(11) **EP 1 528 255 B1**
(45) Date of publication and mention of the grant of the patent: **05.07.2006**
(21) Application number: 04025594.5
(22) Date of filing: 28.10.2004
(51) Int. Cl.: F03G 6/00, H01L 31/045

(54) **Portable power supply**
Tragbare Leistungsversorgungseinheit
Groupe d'alimentation de puissance portatif

(30) Priority: 29.10.2003 JP 2003369028
(43) Date of publication of application: 04.05.2005
(73) Proprietor: SHARP KABUSHIKI KAISHA, Osaka-shi, Osaka 545-8522 (JP)
(72) Inventor: Sakai, Takanori, Katsuragi-shi Nara (JP)
(74) Representative: Müller - Hoffmann & Partner

(56) References cited:
- DE-A1- 3 010 571
- DE-U1- 29 803 536
- FR-A- 2 691 290
- FR-A- 2 745 434
- AL-ORAN B ET AL: "TRANSPORTABLE SOLAR CELL" APPLIED SOLAR ENERGY (GELIOTEKHNIKA), ALLERTON PRESS INC, NEW YORK, US, vol. 30, no. 3, January 1994 (1994-01), pages 82-84, XP000500683 ISSN: 0003-701X

## Description

This application is based on Japanese Patent Application No. 2003-369028 filed with the Japan Patent Office on October 29, 2003, the entire contents of which are hereby incorporated by reference.

The present invention relates to a portable power supply, which can generate electric power by receiving sunlight.

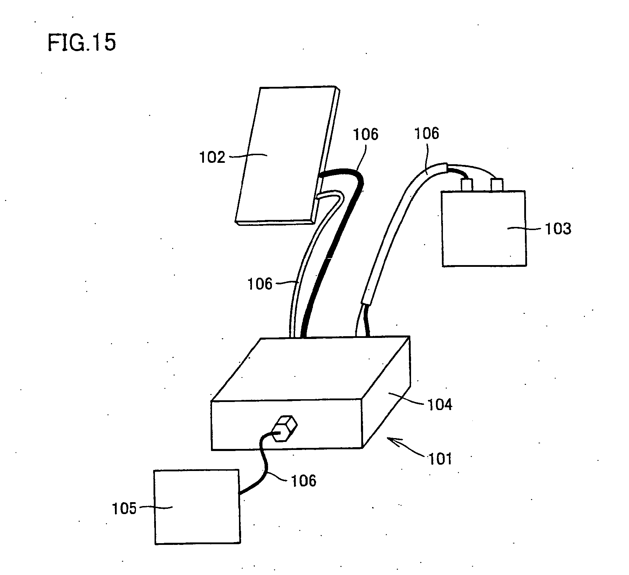

Stand-alone power supply systems, which can generate electric power by receiving sunlight, have been used. As shown in Fig. 15, a conventional stand-alone power supply system includes a solar cell module 102, a rechargeable battery 103, a controller 104 controlling solar cell module 102 and rechargeable battery 103, and an AC electric load 105 connected to controller 104. These components are independent of each other, and are connected together by connection interconnections 106.

The conventional stand-alone power supply system provided with the solar cell module is made of a plurality of components, which are independent of each other, and are connected together by electric interconnections, as already described. Therefore, it is difficult to move the stand-alone power supply system for temporary use. Also, the solar cell module is usually fixed to a base or frame so that it is difficult to change a direction of a surface receiving sunlight.

From document DE 298 03 536 U, a portable power supply is known using two solar panels foldably connected to each other via hinges for charging a battery in the portable power supply. The solar panels are removably attached to the power supply base station so that they may be stored in the attached state during transport and removed during use.

The invention has been developed for overcoming the above problem, and it is an object of the invention to provide a portable power supply allowing easy movement of a stand-alone power supply system.

Another object of the invention is to provide a portable power supply in which attitude of a surface receiving sunlight can be easily changed.

These objects are accomplished by a portable power supply as defined in claim 1.
Advantageous further developments of the invention are subject of the accompanying dependent claims.

According to the structure of the invention, when a user grips and carries the solar cell module, the user can collectively grasp the first and second handles so that the user can easily carry the portable power supply. As a result, when the above structure is used, if only the user hooks the first and second handles on engagement members such as hooks, the above structure functions as the solar cell modules. In addition, provisions for easy attachment to and detachment from the first and second solar cell module portions of first and second battery packs are made. According to the portable power supply of an aspect of the invention, a position of the center of total gravity of the first and second solar cell modules and the first and second battery packs is determined such that the first and second light receiving surfaces form a predetermined angle with respect to the vertical direction when the first and second handles are engaged with an engagement portion. According to this structure, the performance of the solar cell can be utilized more easily and effectively. According to another aspect, when the first and second handles are engaged with hooks or the like, respectively, each of the first and second light receiving surfaces can be easily inclined with respect to the vertical direction.

The foregoing and other objects, features, aspects and advantages of the present invention will become more apparent from the following detailed description of the present invention when taken in conjunction with the accompanying drawings.
Fig. 1 shows light receiving sides of solar cell modules, which can be viewed when a portable power supply of an embodiment is open.
Fig. 2 is a side view of the portable power supply in a closed position according to the embodiment.
Fig. 3 shows a side surface of a battery pack, which can be viewed when the portable power supply of the embodiment is closed.
Fig. 4 shows a state of the portable power supply of the embodiment attained immediately after handles are engaged with hooks.
Fig. 5 shows a state of the portable power supply of the embodiment attained when a predetermined time elapses after the handles are engaged with the hooks.
Fig. 6 shows through holes formed in four corners of each solar cell module of the portable power supply of the embodiment, respectively.
Fig. 7 shows a closed state of the portable power supply shown in Fig. 6.
Fig. 8 shows a state, in which the solar cell modules shown in Fig. 7 are tied together with strings passing through the through holes in the portable power supply to prevent opening of the portable power supply.
Fig. 9 shows a portable power supply of an embodiment provided with handles rotatable with respect to battery packs.
Fig. 10 is a front view of the battery pack with the handle shown in Fig. 9.
Fig. 11 is a side view of the portable power supply with the battery packs having the handles in Fig. 9.
Fig. 12 shows a state of the portable power supply of the embodiment, in which the rotated handles of the battery packs are used as a stand.
Fig. 13 shows a scale formed on a side end surface of the battery pack of the portable power supply of the embodiment.
Fig. 14 shows a state of the portable power supply of the embodiment, in which an angle gauge inserted into the battery pack is taken out.
Fig. 15 shows a conventional stand-alone power supply system.

A portable power supply of an embodiment of the invention will now be described with reference to the drawings.

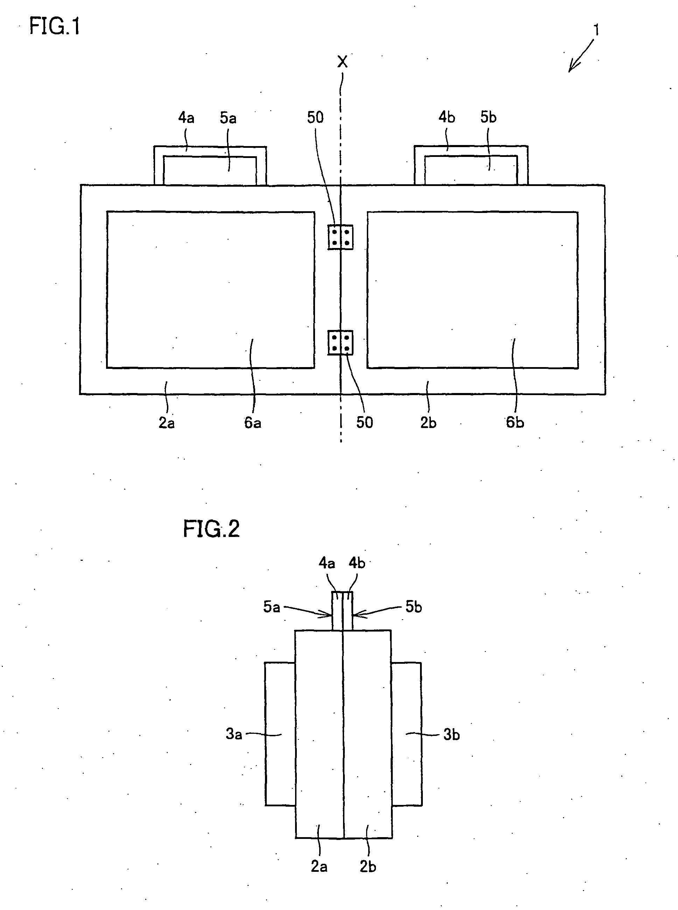

As shown in Fig. 1, a portable power supply 1 of the embodiment includes solar cell modules 2a and 2b. Portable power supply 1 also includes a hinge 50, which allows folding of portable power supply 1 to oppose solar cell modules 2a and 2b to each other.

Fig. 1 shows solar cell modules 2a and 2b in an open state. As shown in Fig. 2, when portable power supply 1 is folded around a rotation axis defined by hinge 50, light receiving surface 6a of solar cell module 2a is opposed to light receiving surface 6b of solar cell module 2b.

Light receiving surface 6a is formed in one of main surfaces of solar cell module 2a, and light receiving surface 6b is formed in one of main surfaces of solar cell module 2b. According to this embodiment, each of solar cell modules 2a and 2b has a substantially flat plate-like form, and has the rectangular main surfaces.

A handle 4a is arranged on one of side end surfaces of solar cell module 2a. A handle 4b is arranged on one of side end surfaces of solar cell module 2b. Each of handles 4a and 4b may be arranged on any one of four side end surfaces of corresponding solar cell module 2a or 2b provided that it does not impede opening and closing of solar cell modules 2a and 2b. Each of handles 4a and 4b may be arranged on a rear surface opposite to corresponding light receiving surface 6a or 6b.

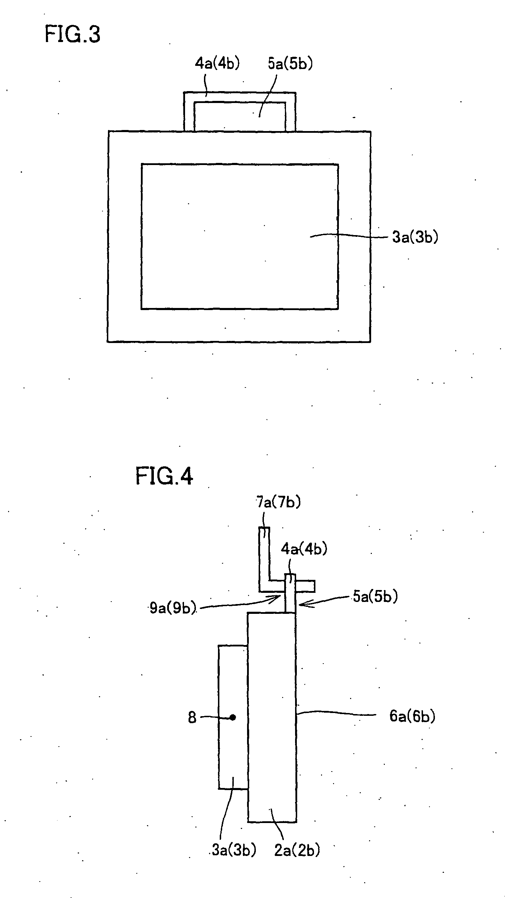

When portable power supply 1 is folded around the rotation center defined by hinge 50 to oppose solar cell modules 2a and 2b to each other, handles 4a and 4b are in contact with each other, as shown in Fig. 2. Thereby, as.shown in Fig. 3, portable power supply 1 of the embodiment is closed such that openings 5a and 5b of handles 4a and 4b substantially overlap with each other. Therefore, the user can grasp handles 4a and 4b as a single handle. It is not necessary to keep handles 4a and 4b in complete contact with each other, and these may be slightly spaced if the user can substantially grasp handles 4a and 4b as a signal handle.

A battery pack 3a is engaged with a rear surface of solar cell module 2a opposite to light receiving surface 6a via an engagement member (not shown). Also, a battery pack 3b is engaged with a rear surface of solar cell module 2b opposite to light receiving surface 6b via an engagement member (not shown). Each of battery packs 3 a and 3b is integrally provided with a rechargeable and a battery charger as well as a controller having functions of an input/output terminal of a DC power supply and an input/output terminal of an AC power supply.

Each of solar cell modules 2a and 2b has a maximum output of 27.5 W, and the rechargeable battery has a capacity of 12V/5Ah. The controller has the input/output terminal of DC 12 V, and the input/output terminal of AC 100 V.

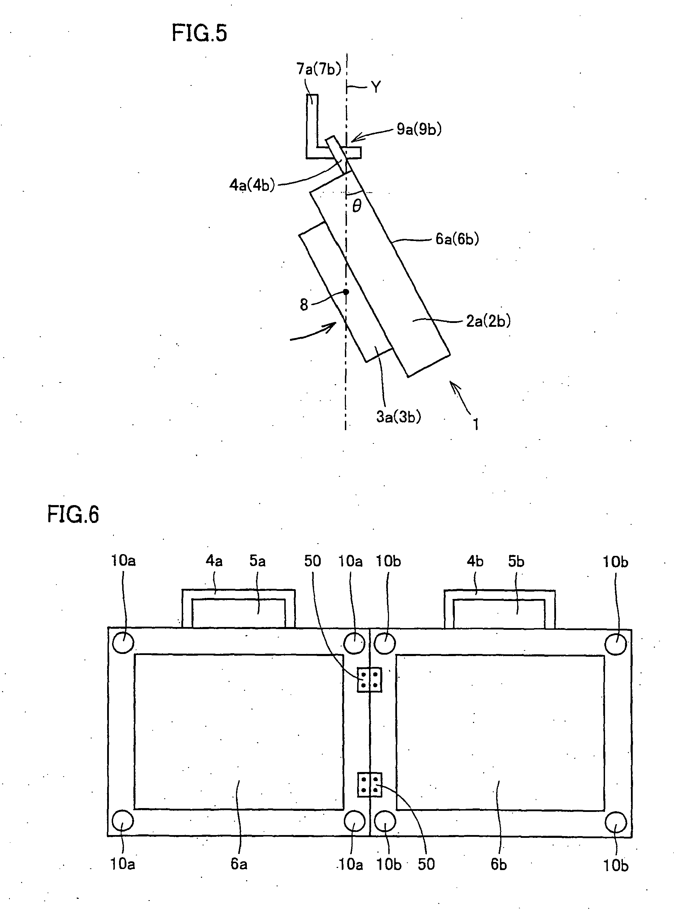

As shown in Fig. 4, when portable power supply 1 of the embodiment is used, handles 4a and 4b are engaged with hooks 7. Handle 4a is arranged in a position shifted toward light receiving surface 6a with respect to the center, which is defined in the direction of the thickness, of solar cell module 2a, and handle 4b is arranged in a position shifted toward light receiving surface 6b with respect to the center, which is defined in the direction of the thickness, of solar cell module 2b. Further, a position 8 of gravity of portable power supply 1 including battery packs 3a and 3b, which are attached to solar cell modules 2a and 2b, respectively, is lower than handles 4a and 4b. As shown in Figs. 4 and 5, position 8 of gravity is located within battery packs 3a and 3b in this embodiment. However, it is merely required that position 8 of gravity is located in a position near the rear side of light receiving surface 6 (6b) i.e., the rear surface of solar module 2a (2b) in comparison with the position, where handle 4a (4b) is attached to battery pack 3a (3b).

According to portable power supply 1 described above, light receiving surfaces 6a and 6b are inclined to form an angle θ with respect to vertical direction Y around rotation centers defined by respective points of contact between handles 4a and 4b and hooks 7a and 7b. Therefore, by hooking handles 4a and 4b on hooks 7a and 7b, respectively, light receiving surfaces 6a and 6b can be positioned perpendicular to the incident direction of the sunlight to the extent possible without using any other structure. Therefore, the solar cell modules can be arranged by a simple manner to allow effective charging.

As shown in Fig. 6, solar cell module 2a is provided at its four corners with through holes 10a, respectively. Solar cell module 2b is provided at its four corners with through holes 10b, respectively. Through holes 10a and 10b are positioned such that each through hole 10a and corresponding one through hole 10b form a single through hole when portable power supply 1 is folded around the rotation axis defined by hinge 50 to oppose light receiving surfaces 6a and 6b to each other.

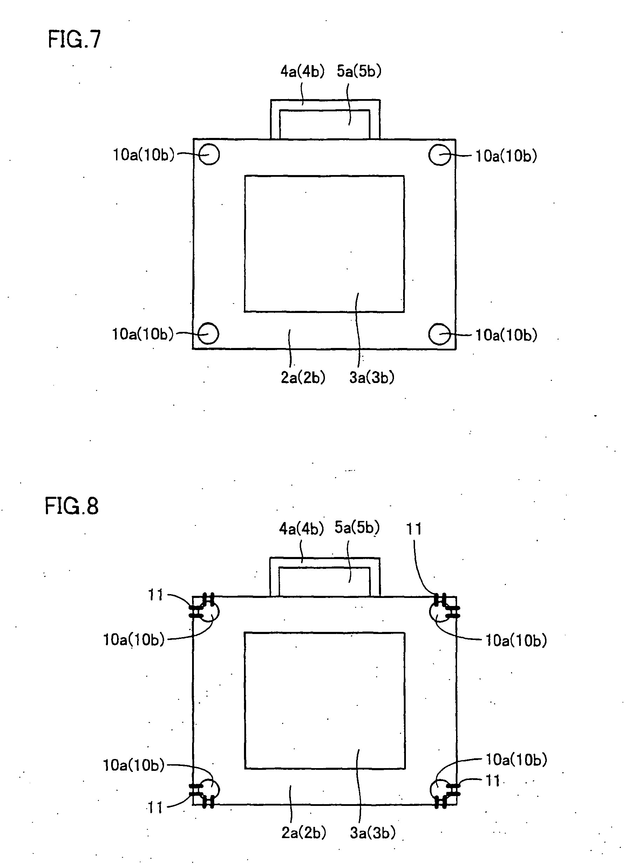

As shown in Fig. 8, therefore, a string 11 can be passed through each through hole formed of through holes 10a and 10b in each corner, and solar cell modules 2a and 2b can be tied together with strings 11. Thereby, it is possible to prevent such an unpreferred situation that portable power supply 1 opens to form an angular space between solar cell modules 2a and 2b while it is being carried.

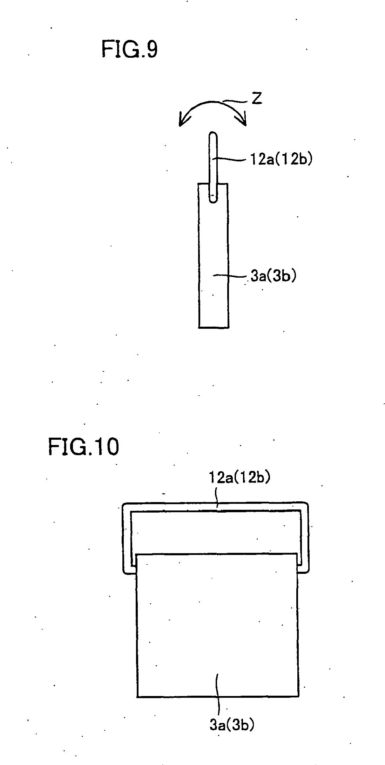

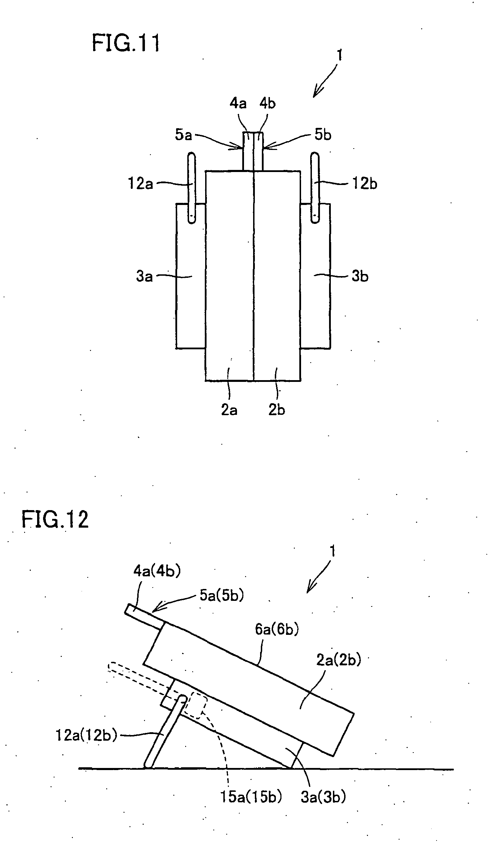

In the foregoing embodiment, battery pack 3 is not provided with any handle for carrying it. However, as shown in Figs. 9 and 10, handles 12a and 12b may be arranged on battery packs 3a and 3b, respectively. Handles 12a and 12b may be rotatable, as indicated by an arrow Z in Fig. 9, with respect to solar cell modules 2a and 2b, respectively. Fig. 11 shows a structure, in which battery packs 3a and 3b provided with handles 12a and 12b are attached to solar cell modules 2a and 2b, respectively.

As shown in Fig. 12, when handles 12a and 12b rotate the same predetermined angle with respect to battery packs 3a and 3b, handles 12a and 12b are engaged with engagement portions 15a and 15b arranged within battery packs 3a and 3b, respectively. Engagement portions 15a and 15b can fix handles 12a and 12b in a stepwise-varying angular position. Therefore, the direction, in which handles 12a and 12b extend, can be changed stepwise with respect to the direction perpendicular to light receiving surfaces 6a and 6b of battery packs 3a and 3b, and the positional relationship between handles 12a and 12b and battery packs 3a and 3b can be fixed after changing the above direction. If engagement portions 15a and 15b are not employed, handles 12a and 12b and battery packs 3a and 3b may be configured to fix the positional relationship between them by frictional forces between handles 12a and 12b and battery packs 3 a and 3b.

According to the above structure, handles 12a and 12b can be used as a stand supporting solar cell modules 2a and 2b. Thereby, the direction or the attitude of light receiving surfaces 6a and 6b with respect to the incident direction of the sunlight can be easily changed. Since handles 12a and 12b are directly used as the stand, it is not necessary to provide a dedicated stand. Therefore, battery packs 3a and 3b can have simple structures.

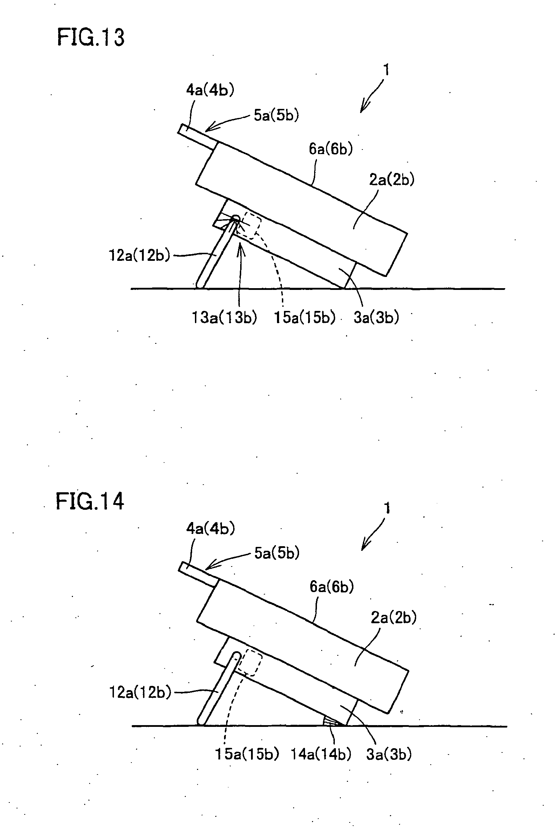

Further, battery packs 3a and 3b may be provided at the side end surfaces, as shown in Fig. 13, with scales 13a and 13b for measuring the angle between the direction of extension of handles 12a and 12b and a reference direction of battery packs 3 a and 3b, i.e., a rotation angle of handles 12a and 12b with respect to battery packs 3a and 3b, respectively. By measuring the angle between the extension direction of handles 12a and 12b and the reference direction of battery packs 3a and 3b, the angle of light receiving surfaces 6a and 6b with respect to the ground surface can be easily determined.

In stead of scales 13a and 13b, as shown in Fig. 14, angle gauges 14a and 14b with scales may be inserted into battery packs 3a and 3b. For measuring the angle of light receiving surfaces 6a and 6b with respect to the ground surface, angle gauges 14a and 14b are taken out from battery packs 3a and 3b, and are located in contact with the ground surface. According to this manner, the angle of light receiving surfaces 6a and 6b with respect to the ground surface can be easily determined.

Consequently, the user, who determined the angle of the sun from the date and time, can change the position or the attitude of portable power supply 1 so that light receiving surfaces 6a and 6b can perpendicularly receive the incident sunlight as much as possible.

Although the present invention has been described and illustrated in detail, it is clearly understood that the same is by way of illustration and example only and is not to be taken by way of limitation, the scope of the present invention being limited only by the terms of the appended claims.

## Claims

1. A portable power supply comprising:
a first solar cell module (2a) provided with a first light receiving surface (6a) for receiving sunlight;
a second solar cell module (2b) provided with a second light receiving surface (6b) for receiving the sunlight; and
a foldable portion (50) being foldable and connecting said first and second solar cell modules (2a, 2b) together,
**characterized in that**
a first handle (4a) is provided on said first solar cell module;
a second handle (4b) provided on said second solar cell module; and
said portable power supply is configured such that, when said foldable portion is in a folded position, an opening (5a) formed by said first handle (4a) and said first solar cell module (2a) substantially overlaps with an opening (5b) formed by said second handle (4b) and said second solar cell module (2b).

2. The portable power supply according to claim 1, **characterized in that**
said first solar cell module (2a) is provided on a rear side of said first light receiving surface (6a) with a first attachment surface allowing attachment of a first battery pack (3 a) thereto, and
said second solar cell module (2b) is provided on a rear side of said second light receiving surface (6b) with a second attachment surface allowing attachment of a second battery pack (3b) thereto.

3. The portable power supply according to claim 2, **characterized in that**
said first battery pack (3 a) is attached to said first attachment surface, and said second battery pack (3b) is attached to said second attachment surface, and
a position (8) of the center of total gravity of said first and second solar cell modules (2a, 2b) and said first and second battery packs (3 a, 3b) is determined such that said first and second light receiving surfaces (6a, 6b) form a predetermined angle with respect to the vertical direction when said first and second handles (4a, 4b) are engaged with an engagement portion.

4. The portable power supply according to claim 1, **characterized in that** said first handle (4a) is arranged in a position shifted toward said light receiving surface (6a) with respect to a center in a direction of a thickness of said first solar cell module (2a), and said second handle (4b) is arranged in a position shifted toward said second light receiving surface (6b) with respect to a center in a direction of a thickness of said second solar cell module (2b).

## Patentansprüche

1. Tragbare Leistungsversorgungseinheit, umfassend:
ein erstes Solarzellenmodul (2a), das mit einer ersten Licht empfangenden Oberfläche (6a) zum Empfangen von Sonnenlicht versehen ist;
ein zweites Solarzellenmodul (2b), das mit einer zweiten Licht empfangenden Oberfläche (6b) zum Empfangen des Sonnenlichts versehen ist; und
einen faltbaren Abschnitt (50), der faltbar ist und das erste und das zweite Solarzellenmodul (2a, 2b) miteinander verbindet,
**dadurch gekennzeichnet, dass**
ein erstes Griffstück (4a) an dem ersten Solarzellenmodul bereitgestellt ist;
ein zweites Griffstück (4b) an dem zweiten Solarzellenmodul bereitgestellt ist; und
die tragbare Leistungsversorgungseinheit derart konfiguriert ist, dass dann, wenn sich der faltbare Abschnitt in einer gefalteten Position befindet, eine durch das erste Griffstück (4a) und das erste Solarzellenmodul (2a) gebildete Öffnung im Wesentlichen eine durch das zweite Griffstück (4b) und das zweite Solarzellenmodul (2b) gebildete Öffnung (5b) überlappt.

2. Tragbare Leistungsversorgungseinheit nach Anspruch 1, **dadurch gekennzeichnet, dass**
das erste Solarzellenmodul (2a) auf einer Rückseite der ersten Licht empfangenden Oberfläche (6a) mit einer ersten Anschlussoberfläche versehen ist, die den Anschluss eines ersten Batteriepakets (3a) an diese erlaubt, und
das zweite Solarzellenmodul (2b) auf einer Rückseite der zweiten Licht empfangenden Oberfläche (6b) mit einer zweiten Anschlussoberfläche versehen ist, die den Anschluss eines zweiten Batteriepakets (3b) an diese erlaubt.

3. Tragbare Leistungsversorgungseinheit nach Anspruch 2, **dadurch gekennzeichnet, dass**
das erste Batteriepaket (3a) an der ersten Anschlussoberfläche befestigt ist und das zweite Batteriepaket (3b) an der zweiten Anschlussoberfläche befestigt ist, und
eine Position (8) des Gesamtschwerpunkts des ersten und des zweiten Solarzellenmoduls (2a, 2b) und des ersten und des zweiten Batteriepakets (3a, 3b) derart bestimmt ist, dass die erste und die zweite Licht empfangende Oberfläche (6a, 6b) einen vorbestimmten Winkel in Bezug auf die vertikale Richtung bilden, wenn das erste und das zweite Griffstück (4a, 4b) mit einem Eingriffabschnitt in Eingriff stehen.

4. Tragbare Leistungsversorgungseinheit nach Anspruch 1, **dadurch gekennzeichnet, dass** das erste Griffstück (4a) in einer Position angeordnet ist, die in Bezug auf eine Mitte in einer Richtung einer Dicke des ersten Solarzellenmoduls (2a) in Richtung der Licht empfangenden Oberfläche (6a) verschoben ist, und das zweite Griffstück (4b) in einer Position angeordnet ist, die in Bezug auf eine Mitte in einer Richtung einer Dicke des zweiten Solarzellenmoduls (2b) in Richtung der zweiten Licht empfangenden Oberfläche (6b) verschoben ist.

## Revendications

1. Alimentation en courant portative comprenant:
un premier module de cellule solaire (2a) muni d'une première surface réceptrice de lumière (6a) destinée à recevoir une lumière solaire;
un second module de cellule solaire (2b) muni d'une seconde surface réceptrice de lumière (6b) destinée à recevoir la lumière solaire; et
une partie pliante (50) apte à être pliée et reliant lesdits premier et second modules de cellule solaire (2a, 2b) entre eux,
**caractérisée en ce que**
une première poignée (4a) est prévue sur ledit premier module de cellule solaire;
une seconde poignée (4b) est prévue sur ledit second module de cellule solaire; et
ladite alimentation en courant portative est configurée pour que, lorsque ladite partie pliante est dans une position pliée, une ouverture (5a) formée par ladite première poignée (4a) et ledit premier module de cellule solaire (2a) et une ouverture (5b) formée par ladite seconde poignée (4b) et ledit second module de cellule solaire (2b) se chevauchent sensiblement.

2. Alimentation en courant portative selon la revendication 1, **caractérisée en ce que**
ledit premier module de cellule solaire (2a) comporte, sur une face arrière de ladite première surface réceptrice de lumière (6a), une première surface de fixation à laquelle un premier bloc de batterie (3a) peut être fixé, et
ledit second module de cellule solaire (2b) comporte, sur une face arrière de ladite seconde surface réceptrice de lumière (6b), une seconde surface de fixation à laquelle un second bloc de batterie (3b) peut être fixé.

3. Alimentation en courant portative selon la revendication 2, **caractérisée en ce que**
ledit premier bloc de batterie (3a) est fixé à ladite première surface de fixation, tandis que ledit second bloc de batterie (3b) est fixé à ladite seconde surface de fixation, et
une position (8) du centre de gravité totale desdits premier et second modules de cellule solaire (2a, 2b) et desdits premier et second blocs de batterie (3a, 3b) est déterminée de façon que lesdites première et seconde surfaces réceptrices de lumière (6a, 6b) forment un angle prédéterminé par rapport à la direction verticale lorsque lesdites première et seconde poignées (4a, 4b) sont en prise avec une partie d'accrochage.

4. Alimentation en courant portative selon la revendication 1, **caractérisée en ce que** ladite première poignée (4a) est disposée dans une position décalée vers ladite première surface réceptrice de lumière (6a) par rapport à un centre dans le sens d'une épaisseur dudit premier module de cellule solaire (2a), tandis que ladite seconde poignée (4b) est disposée dans une position décalée vers ladite seconde surface réceptrice de lumière (6b) par rapport à un centre dans le sens d'une épaisseur dudit second module de cellule solaire (2b).
